(19) Europäisches Patentamt

European Patent Office

Office européen des brevets

(11) **EP 0 849 605 B1**

(12) **EUROPEAN PATENT SPECIFICATION**

(45) Date of publication and mention
of the grant of the patent:
**15.09.2004 Bulletin 2004/38**

(51) Int Cl.⁷: **G01R 31/36**

(21) Application number: **97122363.1**

(22) Date of filing: **18.12.1997**

(54) **Method of determining the current state of charge of an electrical energy storage unit**

Verfahren zum Feststellen des aktuellen Zustands des Ladestromes einer elektrischen
Energiespeicheranordnung

Méthode de détermination de l'état de la charge courante d'un dispositif d'accumulation d'énergie
électrique

(84) Designated Contracting States:
**DE ES FR GB SE**

(30) Priority: **18.12.1996 IT TO961041**

(43) Date of publication of application:
**24.06.1998 Bulletin 1998/26**

(73) Proprietor: **FIAT AUTO S.p.A.**
**10135 Torino (IT)**

(72) Inventors:
• **Cisternino, Maurizio**
**10132 Torino (IT)**

• **Venturi, Massimo**
**10020 Cambiano (IT)**

(74) Representative: **Jorio, Paolo, Dr. Ing. et al**
**Studio Torta S.r.l.,**
**Via Viotti, 9**
**10121 Torino (IT)**

(56) References cited:
**EP-A- 0 637 754     US-A- 5 381 350**

## Description

The invention relates to a method and to a device for determining the current state of charge of an electrical energy storage unit.

The invention is advantageously but not exclusively applied to the determination of the state of charge of an electrical energy storage unit constituted by the connection in series of a plurality of batteries and used on electric or hybrid vehicles, to which the discussion which follows will make explicit reference without thereby losing generality. Furthermore, the discussion which follows will refer to the above-mentioned electrical energy storage unit by using the generic term of battery, in that several batteries connected in series are equivalent to a single battery having an output voltage equal to the sum of the output voltages of each of the above-mentioned individual batteries.

Methods of determining the state of charge of a battery are known and are based on the measurement of a parameter correlated with the said state of charge, such a method is disclosed eg. in EP 0 637 754 A.

One of the parameters that is widely used to determine the state of charge of a battery is the instantaneous internal resistance of the said battery, the value of which is greatly influenced by both the density of the electrolyte and the internal temperature and by the age of the battery and the type of electrodes present.

This method is substantially based on determining instantaneous values of the voltage and the current supplied by the battery, by means of which a calculation is then made of the instantaneous value of the battery's internal resistance, optionally re-processed so as to take account of the effects linked to the above-mentioned parameters. The result obtained in this way is therefore greatly influenced by the dynamic conditions of use of the said battery and varies rapidly according to the performances demanded of the motor vehicle, thus giving rise to changeable and contradictory indications which disorientate the driver, who thus tends to ignore such indications.

Methods of determining the state of charge of a battery based on mathematical models of the discharge of a constant current battery have been proposed to remedy this disadvantage.

These methods do, however, have the disadvantage of supplying indications of the state of charge of the battery which are not very reliable in that as they use mathematical models they do not take account of the dynamic behaviour of the battery itself and are therefore inaccurate and sometimes unreliable.

The object of the invention is to produce a method which enables reliable indications about the state of charge of an electrical energy storage unit to be supplied in a simple and economical manner.

According to the invention a method of determining the current state of charge of an electrical energy storage unit is produced, which comprises, in combination, the phases of:

- acquiring a plurality of pairs of voltage/current values each comprising an instantaneous value of voltage generated by the said storage unit and a corresponding instantaneous value of current supplied by the said storage unit;

- determining a curve interpolating the said pairs of voltage/current values, the said interpolating curve defining a current operative voltage/current characteristic of the said storage unit;

- sub-dividing a graph of the voltage/current characteristics of the said storage unit into a plurality of reference windows each associated with a corresponding reference state of charge of the storage unit;

- associating the said current operative voltage/current characteristic with the said graph of the voltage/current characteristics;

- identifying, from among the said reference windows, a specific reference window containing the current operative voltage/current characteristic;

- determining, from among the said reference states of charge, a specific reference state of charge associated with the said specific reference window identified; and

- determining the said current state of charge of the said storage unit on the basis of the said specific reference state of charge.

The invention further relates to a device for determining the current state of charge of an electrical energy storage unit, which comprises, in combination:

- means of acquiring a plurality of pairs of voltage/current values, each comprising an instantaneous value of voltage generated by the said storage unit and a corresponding instantaneous value of current supplied by the said storage unit;

- means of calculating a curve interpolating the said instantaneous voltage and current values, the said interpolating curve defining a current operative voltage/current characteristic of the said storage unit;

- means of storing a plurality of reference windows sub-dividing a graph of the voltage/current characteristics and each associated with a corresponding reference state of charge of the said storage unit;

- means of associating the said current operative voltage/current characteristic with the said graph of the voltage/current characteristics;

- means of identifying a specific reference window from among the said reference windows containing the said operative voltage/current characteristic;

- means of assessing a specific reference state of charge of the storage unit associated with the said specific reference window identified; and

- means of determining the said current state of charge on the basis of the said specific reference state of charge.

For a better understanding of the invention, two preferred embodiments will now be described, purely by way of non-exhaustive example, with reference to the accompanying drawings in which:

Figs. 1 and 2 are wiring diagrams of equivalent circuits of a battery;

Fig. 3 is a diagram of the progress of resistances of a battery as a function of the state of charge of the said battery;

Figs. 4 and 5 are voltage/current characteristics of the battery; and

Figs. 6-9 are flow diagrams relating to the two embodiments of the method to which the invention relates.

To describe the method according to the invention it is necessary first of all briefly to illustrate the equivalent electrical model of a battery so as to be able to determine accurately which are the real operating services of the battery in response to the various stresses.

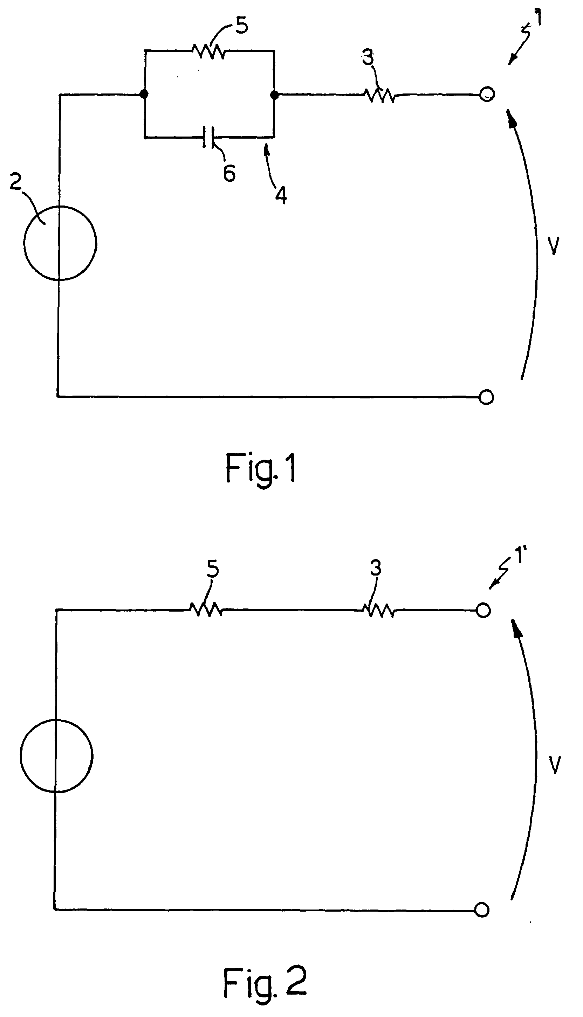

Fig. 1 shows an equivalent electrical circuit of a battery suitable for describing the behaviour of the battery during typical discharge and charge cycles of electric vehicles and in the presence of phenomena which are slowly variable over time with time constants of the order of about ten seconds.

The electrical circuit of Fig. 1, denoted in its entirety by 1, comprises an ideal voltage generator 2, a first resistor 3 connected in series to the voltage generator 2, and an impedance 4 also connected in series to the voltage generator 2 and consisting in its turn of a resistor 5 and a capacitor 6 interconnected in parallel.

The electrical components of the circuit 1 enable the various electro-chemical phenomena which take place in a battery to be modelled. In particular, the value of the electromotive force E generated by the voltage generator 2 is correlated to the density of the electrolyte inside the battery, the resistance $R_\Omega$ of the first resistor 3 is correlated to the resistance of the battery's leads, whilst the resistance $R_d$ and the capacitance $C_d$

of the second resistor 5 and of the capacitor 6 are correlated to the diffusion phenomena of the ions of the electrolyte, and in particular to the delays in propagation of such ions from the inside of the battery towards the electrodes of the said battery.

Furthermore, as the resistance $R_\Omega$ of the first resistor 3 and the resistance $R_d$ of the second resistor 5 are models of electrochemical phenomena of the battery, they are also functions of a parameter $\rho$ known by the term "Dod - Depth of discharge" of the battery, the value of which is indicative of the battery's state of charge; in particular, the parameter p may assume any value between 0, indicative of a fully charged battery, and 80%, indicative of a fully discharged battery, inclusive.

A model of the battery entirely equivalent to the model shown in Fig. 1 is shown in Fig. 2.

Fig. 2 shows an electrical circuit, denoted by 1', equivalent to the circuit 1 of Fig. 1 and substantially identical to it. The only difference lies in the fact that the propagation delay phenomena of the ions of the electrolyte from the inside of the battery towards the electrodes of the said battery are modelled solely by means of the second resistor 5 of resistance $R_d$ across which, however, the instantaneous value of the voltage drop $\Delta V_d$ is not proportional to the instantaneous value I of the current supplied by the voltage generator 2 but rather is proportional to the mean value $I_m$ of that current, whilst the instantaneous value of the voltage drop $\Delta V_\Omega$ across the resistor 3 remains proportional to the instantaneous value I of the current supplied by the voltage generator 2.

In particular, according to this model we have:

$$\Delta V_d = R_d \cdot I_m$$

$$\Delta V_\Omega = R_\Omega \cdot I$$

Therefore the value of the on-load voltage between the battery terminals is:

$$V(t) = E - R_d \cdot I_m - R_\Omega \cdot I \qquad 1)$$

in which the term $\Delta V_\Omega$ represents the voltage drop due to the conductors of the battery whilst the term $\Delta V_d$ represents the diffusion voltage or a term which tends to moderate the sudden variations in the output voltage due to current peaks.

In particular, the equation 1) enables us to emphasize the fact that the value of the on-load voltage between the battery's terminals depends not only on the instantaneous value of the current supplied by it but also on its mean value, and it is on this observation that the principle of the invention is based, in the manner that is described in greater detail below.

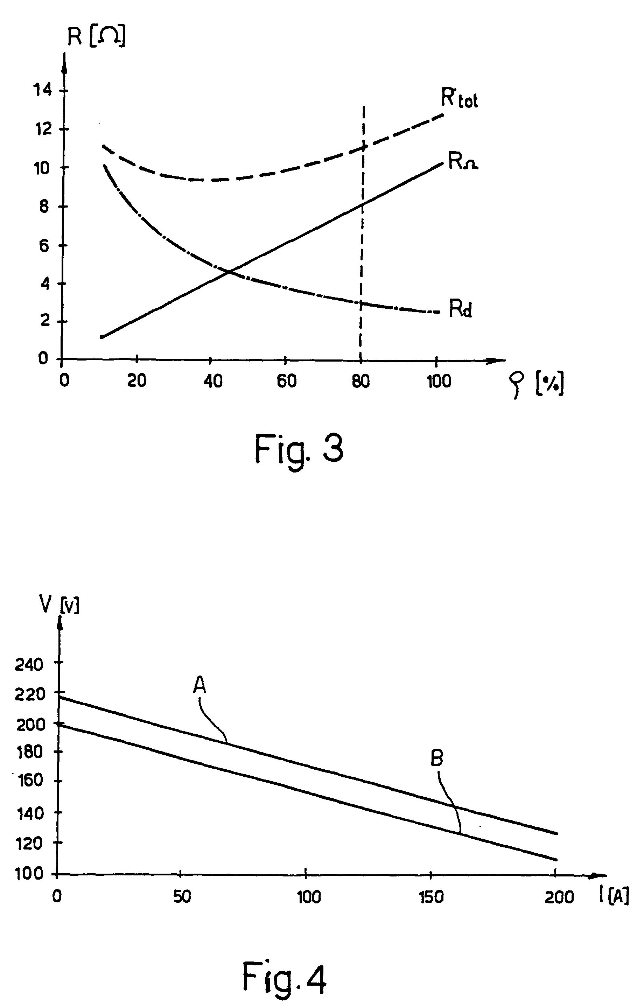

For example Fig. 3 shows a graph of the progress of the resistance $R_\Omega$ of the first resistor 3 and of the resistance $R_d$ of the second resistor 5 as a function of the depth $\rho$ of discharge of the battery in the case of a lead battery; Fig. 3 also shows the progress of the overall resistance $R_{tot}$ of the battery as a function of the depth $\rho$ of discharge of the said battery.

As can be seen in Fig. 3, the overall resistance $R_{tot}$ of the battery does not progress in a linear manner but has an initial decreasing section for values of $\rho$ between 0 and 30% inclusive, a substantially constant intermediate section for values of $\rho$ between 30% and 50% inclusive and an increasing end section for values of $\rho$ between 50% and 100% inclusive.

The courses of the resistances of Fig. 3 are also plotted for values of $\rho$ in excess of 80% even though a state prohibiting the use of the battery corresponds to such values, as will be described in greater detail below.

Fig. 4 further shows a graph on which are plotted two voltage/current characteristics of the battery, denoted by the letters A and B, supplied by the battery maker and each relating to a particular state of charge of the battery.

In particular, the voltage/current characteristics A and B, each defined as the progress of the voltage generated by the battery as a function of the current supplied by it in the course of the operation of the vehicle, show the traditional monotonic decreasing course as the current supplied by it increases and relate to values $\rho$ of the depth of battery discharge equal to 60% and, respectively, 80%.

In detail, the voltage/current characteristics A and B sub-divide the graph of the voltage/current characteristics into three reference windows, each associated with a state of charge of the battery and having particular meanings for the use of the battery:

- the area above the characteristic A ($\rho$ less than 60%) defines the "operative" area of the battery, in that the points contained in that area are defined by pairs of voltage/current values of the battery which are indicative of a sufficient state of charge of the battery, i.e. such as to permit a normal use of the vehicle;

- the inclusive area between the characteristics A and B ($\rho$ between 60% and 80% inclusive) defines the "reserve" area of the battery, in that the points contained in that area are defined by pairs of voltage/current values of the battery indicative of a reduced state of charge of the battery, i.e. such as to be just sufficient to drive the vehicle to an electrical energy refuelling station; and

- the area below the characteristic B ($\rho$ greater than 80%) defines the "prohibited" area of the battery, in that the points contained in that area are defined by pairs of voltage/current values of the battery indicative of an insufficient state of charge of the battery, i.e. such as to advise against any further use of the vehicle so as not to damage the battery beyond repair.

The sub-division of the graph of the voltage/current characteristics in Fig. 4 into three areas indicative of the state of charge of the battery and the fact emphasized above that the on-load voltage supplied by the battery also depends on the mean value of the current supplied by it now permit an explanation of the principle on which the invention is based.

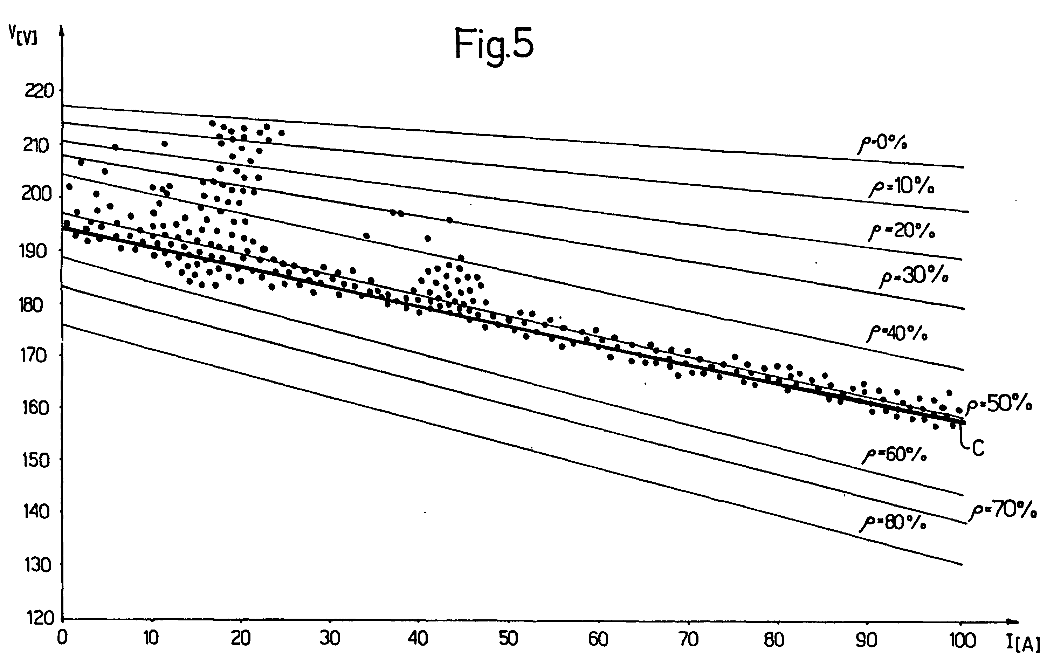

In fact, the invention is based on the principle of acquiring a plurality of pairs of voltage/current values of the battery, each pair comprising an instantaneous value of voltage generated by the battery and a corresponding instantaneous value of current supplied by the said battery; determining a curve interpolating the above-mentioned pairs of voltage/current values and defining a current operative voltage/current characteristic of the storage unit; sub-dividing, as shown in Fig. 5, the graph of the voltage/current characteristics into a plurality of reference windows, each associated with a corresponding reference state of charge of the battery; plotting the current operative voltage/current characteristic on the graph of the voltage/current characteristics of Fig. 5; identifying a specific reference window containing the current operative voltage/current characteristic; determining a specific reference state of charge of the battery associated with the specific reference window identified; and determining the current state of charge of the battery on the basis of the specific state of charge of the battery associated with the specific reference window identified.

In particular, the operation of sub-dividing the graph of the voltage/current characteristics into a plurality of reference windows provides to plot a plurality of reference voltage/current characteristics of the storage unit on the graph of the voltage/current characteristics, each of which is associated with a corresponding reference value of the depth of discharge of the storage unit.

Furthermore, each pair of adjacent reference voltage/current characteristics delimits a respective one of the above-mentioned reference windows and therefore the operation of determining a specific state of charge, associated with the specific reference window containing the current operative voltage/current characteristic, provides to determine the pair of reference values of the depth of discharge associated with the pair of reference voltage/current characteristics delimiting such specific reference window and the operation of determining the current state of charge of the battery provides to determine a depth of discharge value between the above-mentioned depth of discharge reference values inclusive and associated with the current operative voltage/current characteristic.

According to the invention, furthermore, the reference values of the depth of discharge which are used are, respectively, $\rho_0 = 0$, $\rho_1 = 10\%$, $\rho_2 = 20\%$, $\rho_3 = 30\%$, $\rho_4 = 40\%$, $\rho_5 = 50\%$, $\rho_6 = 60\%$, $\rho_7 = 70\%$ and $\rho_8 = 80\%$ and the pairs of voltage/current values required to determine the current operative voltage/current characteristic are acquired at a pre-determined time interval Tc, for example 1 second, apart.

Furthermore, the current operative voltage/current characteristic is determined after having acquired a number of pairs of voltage/current values such as for which the amount of charge supplied by the battery from the start of the operations for acquiring the pairs of voltage/current values is at least equal to a pre-determined amount of charge, such as 2 Ah (ampere-hours), and the value of that charge can be calculated in known manner by means of an integral over time of the current supplied by the battery.

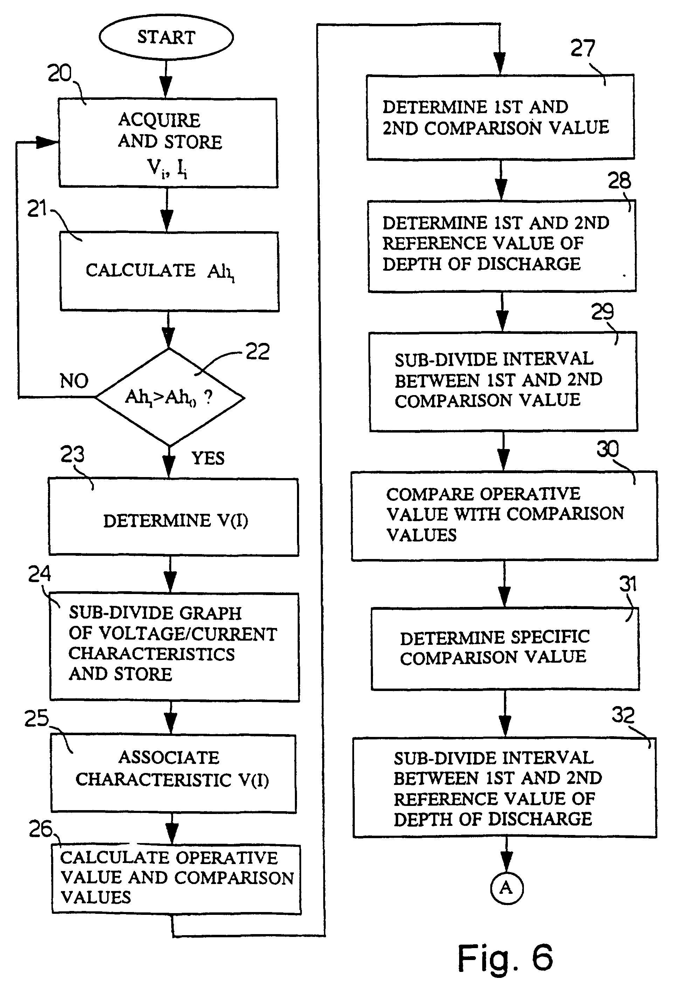

To obtain the value of the depth of discharge of the battery which enables the state of charge of the battery to be defined, it is necessary to carry out the operations described below with reference to the flow diagrams of Figs. 6-8, which relate to a first preferred embodiment of the method to which the invention relates and are implemented by a control unit of the vehicle (not shown) of known type, to which explicit reference will be made below.

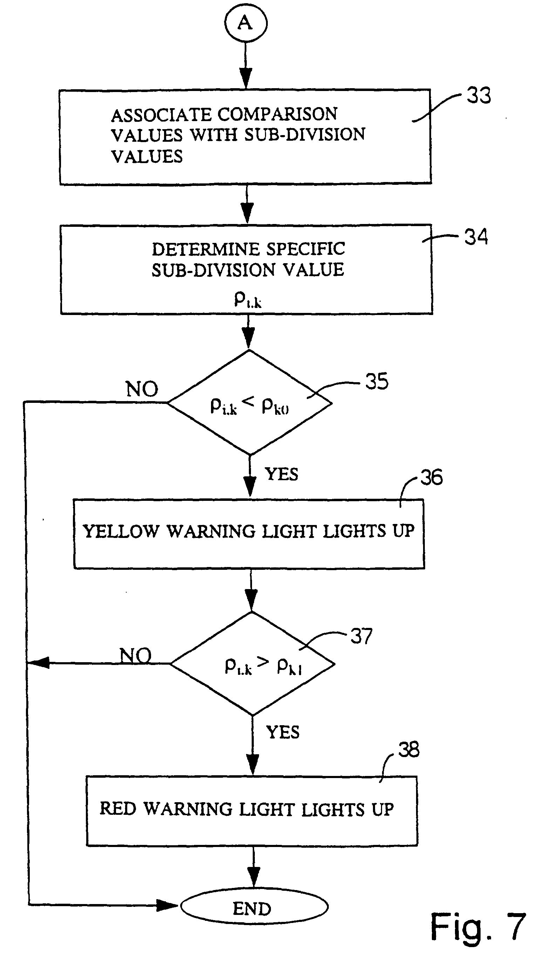

According to the illustrations in Figs. 6 and 7, initially the unit repeats a plurality of times the operations described below with reference to blocks 20-22 and each of the repeats will be marked with the subscript "i".

In each repeat i, the unit acquires and stores a pair of voltage/current values $V_i$, $I_i$ of the battery (block 20).

The unit then calculates, and stores, the amount of charge $Ah_i$ supplied by the battery between the start of the acquisition operations and the current i'th repeat by means of the following equation (block 21):

$$Ah_i = Ah_{i-1} + \frac{I_i \cdot T_c}{3600} \qquad 2)$$

in which $Ah_{i-1}$ is the amount of charge supplied by the battery between the start of the operations and the repeat i-1, $I_i$ is the instantaneous value of the current supplied by the battery at the i'th repeat and $T_c$ is the sampling time, i.e. the time interval passing between one acquisition and the next.

Furthermore, equation 2) is none other than a summation of the amount of charge supplied by the battery between the start of the acquisition operations and the i'th repeat.

The unit then compares the value of the amount of charge $Ah_i$ calculated at the i'th repeat with a pre-determined threshold value $Ah_0$ (block 22).

If the calculated value of the amount of charge $Ah_i$ is less than the above-mentioned pre-determined threshold value $Ah_0$ (output NO from block 22), then the unit carries out the operations described in blocks 20 and 21 again to acquire and store a new pair of voltage/current values and to calculate a new value of amount of charge supplied by the battery.

If, on the other hand, the calculated value of the amount of charge $Ah_i$ is greater than the above-mentioned pre-determined threshold value $Ah_0$ (output SI (YES) from block 22), then the unit determines, and stores, a curve V(I) interpolating the above-mentioned pairs of voltage/current values $V_i$, $I_i$ of the battery (block 23); in particular this interpolating curve represents, because of the way it is constructed, the current operative voltage/current characteristic V(I) of the battery.

In particular, the unit determines the equation of a straight line interpolating the above-mentioned pairs of voltage/current values $V_i$, $I_i$ by means of the known method of linear regression based on the minimization of the root-mean-square deviation, as described in detail, for example, in "ELEMENTI DI PROBABILITA' E STATISTICA" by Piero Galeotti - Levrotto & Bella 1983, Chapter XVIII.6, pp. 408-409.

The unit then sub-divides a graph of the voltage/current characteristics, such as that of Fig. 5, into a plurality of reference windows, each of which is associated with a corresponding pair of reference values $\rho_i$, $\rho_{i+1}$ of the depth of discharge of the battery (block 24). Each pair of reference values $\rho_i$, $\rho_{i+1}$ of the depth of discharge of the battery thus defines the state of charge of the battery associated with the respective reference window.

In particular, as described above, to sub-divide the graph of the voltage/current characteristics into a plurality of reference windows, the unit associates with that graph a plurality of reference voltage/current characteristics of the battery, denoted in Fig. 5 by $V_0(I)$-$V_8(I)$ and represented by a thin line; furthermore, the reference voltage/current characteristics $V_0(I)$-$V_8(I)$ are each associated with a corresponding reference value $\rho_i$, $\rho_{i+1}$ of the depth of discharge of the battery and delimit, at adjacent pairs $V_i(I)$, $V_{i+1}(I)$, a respective one of the above-mentioned reference windows.

Furthermore, the unit stores both the reference voltage/current characteristics $V_0(I)$-$V_8(I)$ of the battery and the respective reference windows delimited by them on the graph of the voltage/current characteristics of the battery (block 24).

The unit then associates the current operative voltage/current characteristic V(I) calculated in block 23 with the graph of the voltage/current characteristics of Fig. 5 (block 25); in this Fig. the current operative voltage/current characteristic V(I) is denoted by a thick line and the letter C.

At this point the unit calculates an operative value associated with the operative voltage/current characteristic V(I) and a plurality of comparison values each associated with a respective reference voltage/current characteristic $V_0(I)$-$V_8(I)$ (block 26).

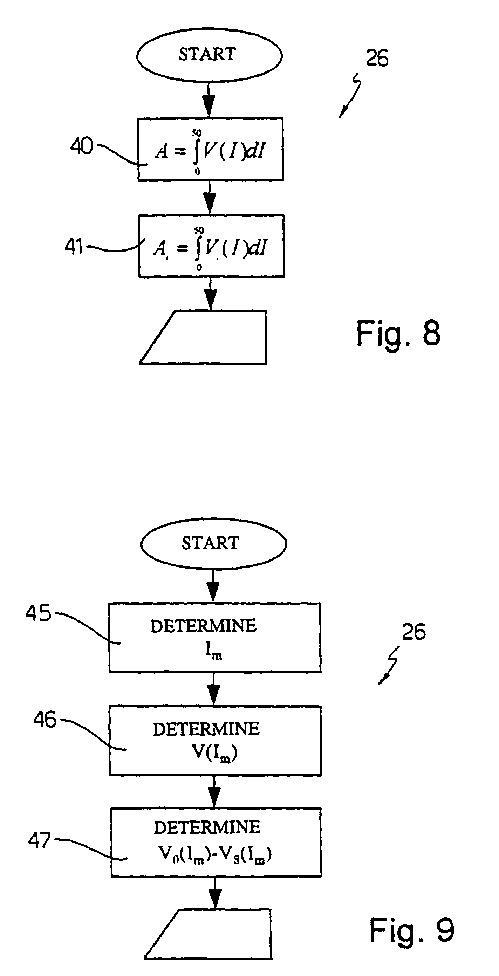

According to a first preferred embodiment shown in Fig. 8, the unit calculates the above-mentioned operative value, denoted by A, as the integral of the current operative voltage/current characteristic V(I) between a pre-determined first and second integration limit (block 40) and each of the above-mentioned comparison values, denoted by $A_0$-$A_8$, as the integral of a respective reference voltage/current characteristic $V_0(I)$-$V_8(I)$ between the above-mentioned pre-determined first and second integration limit (block 41).

In this way, the above-mentioned comparison values $A_0$-$A_8$ are consequently each associated with the value $\rho_0$-$\rho_8$ of the depth of discharge of the respective reference voltage/current characteristic $V_0(I)$-$V_8(I)$ and define a sequence of ordered consecutive values.

According to this embodiment, furthermore, the above-mentioned integrals are calculated between a zero current value and a pre-determined current value such as 50 A; in particular, the second integration limit is a value determined experimentally and represents the mean value of the current supplied by the battery in the course of normal urban use of the vehicle.

With reference once again to Figs. 6 and 7, the unit then determines, from among the above-mentioned plurality of comparison values $A_0$-$A_8$, a first and a second comparison value $A_i$, $A_{i+1}$, consecutive between them and between which the operative value A calculated in block 26 is included (block 27).

In particular, in this way, as described above, the determination of the first and the second comparison value $A_i$, $A_{i+1}$ makes it possible to identify, from among the above-mentioned reference windows, a specific reference window containing the current operative voltage/current characteristic V(I).

The unit then determines a first and a second reference value $\rho_i$, $\rho_{i+1}$ of the depth of discharge associated with the first and, respectively, the second comparison value $A_i$, $A_{i+1}$ (block 28). In particular, in this way, as described above, the determination of the first and of the second reference value $\rho_i$, $\rho_{i+1}$ of the depth of discharge makes it possible to determine a specific state of charge of the battery associated with the specific reference window identified.

The unit then compares the operative value A with the first and the second comparison value $A_i$, $A_{i+1}$ to determine an operative relationship between the operative value A and the said first and the second comparison values $A_i$, $A_{i+1}$.

In particular, to determine the above-mentioned operative relationship, the unit sub-divides the inclusive interval between the first and the second comparison value $A_i$, $A_{i+1}$ into a plurality of sub-intervals, each associated with a respective comparison value $A_{i,0}$-$A_{i,9}$; the comparison values $A_{i,0}$-$A_{i,9}$ are therefore included between the above-mentioned first and second comparison value $A_i$, $A_{i+1}$ (block 29). In the example described, the inclusive interval between the first and the second comparison value $A_i$, $A_{i+1}$ is sub-divided into ten sub-intervals having the same size so that the sub-division of the interval is linear.

The unit then compares the operative value A with the comparison values $A_{i,0}$-$A_{i,9}$ (block 30) and determines, from among the comparison values $A_{i,0}$-$A_{i,9}$, a specific comparison value $A_{i,k}$ closest to the operative value A (block 31).

In particular, the determination of the specific comparison value $A_{i,k}$ closest to the operative value A thus makes it possible to determine the above-mentioned operative relationship between the operative value A and the first and the second comparison value $A_i$, $A_{i+1}$.

The unit then sub-divides the inclusive interval between the first and the second reference value $\rho_i$, $\rho_{i+1}$ of the depth of discharge calculated in block 28 into a plurality of sub-intervals, each associated with a respective sub-division value $\rho_{i,0}$-$\rho_{i,9}$; the sub-division values $\rho_{i,0}$-$\rho_{i,9}$ are therefore included between the above-mentioned first and second reference value $\rho_i$, $\rho_{i+1}$ of the depth of discharge (block 32). In the example described, the inclusive interval between the first and the second reference value $\rho_i$, $\rho_{i+1}$ of the depth of discharge is sub-divided into ten sub-intervals having the same size so that the sub-division of the interval is linear.

The unit then associates each comparison value $A_{i,0}$ - $A_{i,9}$ with a corresponding sub-division value $\rho_{i,0}$ - $\rho_{i,9}$ (block 33) and from among the sub-division values $\rho_{i,0}$ - $\rho_{i,9}$ it determines a specific sub-division value $\rho_{i,k}$ associated with the specific comparison value $A_{i,k}$ determined in block 31 (block 34).

In other words, the unit determines an operative value $\rho$ of the depth of discharge which has the above-mentioned operative relationship with the above-mentioned first and second reference value $\rho_i$, $\rho_{i+1}$ of the depth of discharge, in a similar manner to that found between the operative value A, with which the operative value $\rho$ of the depth of discharge is associated, and the first and the second comparison value $A_i$, $A_{i+1}$ with which the first and second reference value $\rho_i$, $\rho_{i+1}$ of the depth of discharge are associated.

This specific sub-division value $\rho_{i,k}$ thus represents the current state of charge of the battery and is used to indicate the said state of charge to the driver, by means, for example, of an index indicator arranged on the vehicle's dashboard.

Furthermore, the unit compares the specific sub-division value $\rho_{i,k}$ calculated with pre-determined threshold values to determine whether the battery is in one of the above-mentioned states, "operative", "reserve" or "prohibited", and indicate the "reserve" condition to the driver by means of the illumination of a yellow warning light and the "prohibited" condition by means of the illumination of a red warning light on the vehicle's dashboard.

In particular the unit checks (block 35) whether the specific sub-division value $\rho_{i,k}$ calculated is greater than a first threshold value $\rho_{k0}$ equal to 60% (limit value of the "operative" zone of Fig. 4).

If $\rho_{i,k}$ is less than $\rho_{k0}$ (output NO from block 35), then the battery is in a sufficient state of charge for the normal use of the vehicle and the unit does not make any particular visible indication to the driver, otherwise, if $\rho_{i,k}$ is greater than $\rho_{k0}$ (output SI (YES) from block 35) then the battery is at least in a reduced charge state and so the unit controls the illumination of the yellow warning light on the dashboard which indicates to the driver that the battery is "on reserve" (block 36).

Subsequently, the unit (block 37) checks whether the specific sub-division value $\rho_{i,k}$ calculated is greater than a second threshold value $\rho_{k1}$ equal to 80% (limit value of the "reserve" zone of Fig. 4).

If $\rho_{i,k}$ is less than $\rho_{k1}$ (output NO from block 37) then the battery is only in a reduced state of charge (reserve) but not in an insufficient state of charge (prohibited) and so the unit does not make any further indication to the driver, otherwise, if $\rho_{i,k}$ is greater than $\rho_{k1}$ (output SI (YES) from block 37), then the battery is in an insufficient charge state and so the unit controls the illumination of the red warning light on the dashboard which tells the driver that the charge of the battery is such as to advise against any further use of the vehicle so as not to damage the battery beyond repair (block 38).

The operations described in blocks 20-38 are then repeated on a cyclical basis to update the indication of the state of charge of the battery.

Fig. 9 shows a flow diagram relating to a second embodiment used to calculate the above-mentioned operative value described in block 26 of Fig. 6.

According to this second embodiment, the unit calculates the above-mentioned operative value, denoted in Fig. 9 by $V(I_m)$, first determining a mean current value $I_m$ on the basis of the instantaneous current values $I_i$ of the pairs of voltage/current values $(V_i, I_i)$ acquired (block 45).

The unit then determines an operative point $V(I_m)$ of the current operative voltage/current characteristic $V(I)$ corresponding to the mean value $I_m$, which defines the above-mentioned operative value $V(I_m)$ associated with the current operative voltage/current characteristic $V(I)$ (block 46) and a plurality of comparison points $V_0(I_m)-V_8(I_m)$ of the reference voltage/current characteristics $V_0(I)-V_8(I)$ corresponding to the mean value $I_m$, which define the above-mentioned comparison values $V_0(I_m)-V_8(I_m)$ each associated with a respective reference voltage/current characteristic $V_0(I)-V8(I)$ (block 47).

At this point the unit carries out the operations described with reference to blocks 27-38 of Figs. 6 and 7 in which, however, the operative value $V(I_m)$, the reference values $V_0(I_m)-V_8(I_m)$ and the comparison values $V_{i,0}(I_m)-V_{i,9}(I_m)$ are used, respectively, in place of the operative value A, the reference values $A_0-A_8$ and the comparison values $A_{i,0}-A_{i,9}$.

The advantages of the method are as follows.

First of all, the method according to the invention is based on the determination of a current operative voltage/current characteristic $V(I)$ of the battery obtained by means of the acquisition of a plurality of instantaneous values of voltage and current $V_i$, $I_i$ of the said battery and the calculation of a linear regression of such instantaneous values. This enables the instantaneous variations of the voltage and current of the battery to be averaged and indications of the current state of charge of the battery to be supplied, which are reliable in that they are not based on the instantaneous values of voltage and current.

Furthermore, the current operative voltage/current characteristic of the battery determined according to the method enables account to be taken, in the indications supplied to the driver, not only of the dynamic behaviour of the battery but also of the temperature of use and the age of the said battery.

In fact, the effect of temperature on the voltage/current characteristic is to move the said characteristic and, in particular, in the case of extremely low temperature, to move the voltage/current characteristic of Fig. 5 downwards and so the driver is notified of a current state of charge of the battery which is lower than the said battery's internal state, precisely because at that temperature the battery is not capable of providing the services corresponding to its internal state of charge.

A similar assessment may be made not only as regards the effect of the age of the battery but also as regards any other secondary effect on the battery such as the oxidation of the terminals connecting the battery to the vehicle, a loosening of their connections, any intrinsic defect in the said battery etc.

Furthermore, the current operative voltage/current characteristic of the battery determined according to the method enables account to be taken of the recharging of the battery which takes place during a braking manoeuvre of the vehicle, during which the battery does not supply current but absorbs it.

In this case, in fact, the internal state of charge of the battery increases and the effect of this re-charge manifests itself on the current operative voltage/current characteristic by means of a movement of the said characteristic upwards and so the driver is notified of a greater current state of charge.

Finally, the method according to the invention may be applied to the determination of the current state of charge of any type of electrical energy storage unit used in any field of technology.

Finally, it will be evident that modifications and variants may be introduced to the method described and illustrated here without thereby departing from the protective scope of the invention as defined in the claims.

For example, the number of reference voltage/current characteristics $V_0(I)-V_8(I)$ sub-dividing the graph of the characteristics could be different from that described and the comparison values $[A_{i,0}-A_{i,9}]$ into which the inclusive interval between the first and the second comparison value $A_i$, $A_{i+1}$ is sub-divided and the sub-

division values $\rho_{i,0}$ - $\rho_{i,9}$ into which the inclusive interval between the first and the second reference value $\rho_i$, $\rho_{i+1}$ of the depth of discharge is sub-divided could be different in number from that described.

Furthermore, the sub-intervals into which the inclusive intervals between the first and the second comparison value $A_i$, $A_{i+1}$ and between the first and the second reference value $\rho_i$, $\rho_{i+1}$ of the depth of discharge are sub-divided could not have the same size so that the sub-division of such intervals would be non-linear.

## Claims

1. Method of determining the current state of charge of an electrical energy storage unit, which comprises, in combination, the phases of:

   - acquiring a plurality of pairs of voltage/current values ($V_i$, $I_i$) each comprising an instantaneous value of voltage ($V_i$) generated by the said storage unit and a corresponding instantaneous value of current ($I_i$) supplied by the said storage unit;

   - determining a curve (V(I)) interpolating the said pairs of voltage/current values ($V_i$, $I_i$), the said interpolating curve defining a current operative voltage/current characteristic (V(I)) of the said storage unit;

   - sub-dividing a graph of the voltage/current characteristics of the said storage unit into a plurality of reference windows each associated with a corresponding reference state of charge ($\rho_i$, $\rho_{i+1}$) of the storage unit;

   - associating the said current operative voltage/current characteristic (V(I)) with the said graph of the voltage/current characteristics;

   - identifying, from among the said reference windows, a specific reference window containing the said current operative voltage/current characteristic (V(I));

   - determining, from among the said reference states of charge ($\rho_0$-$\rho_8$), a specific reference state of charge ($\rho_i$, $\rho_{i+1}$) associated with the said specific reference window identified; and

   - determining the said current state of charge ($\rho_{i,k}$) of the said storage unit on the basis of the said specific reference state of charge ($\rho_i$, $\rho_{i+1}$).

2. Method according to Claim 1, **characterized in that** the said phase of sub-dividing a graph of the voltage/current characteristics comprises the phase of:

   - associating a plurality of reference voltage/current characteristics ($V_0$(I)-$V_8$(I)) of the said storage unit with the said graph of the voltage/current characteristics, each of the said reference voltage/current characteristics ($V_0$(I)-$V_8$(I)) being associated with a corresponding reference state of charge ($\rho_0$-$\rho_8$) of the storage unit and each pair of adjacent reference voltage/current characteristics ($V_i$(I), $V_{i+1}$(I)) delimiting a respective one of the said reference windows.

3. Method according to Claim 2, **characterized in that** the said phase of identifying a specific reference window comprises the phases of:

   - calculating an operative value (A; V($I_m$)) associated with the said current operative voltage/current characteristic (V(I));

   - calculating a plurality of comparison values ($A_0$-$A_8$; $V_0$($I_m$)-$V_8$($I_m$)), each associated with a respective one of the said reference voltage/current characteristics ($V_0$(I)-$V_8$(I)), each of the said comparison values ($A_0$-$A_8$; $V_0$($I_m$)-$V_8$($I_m$)) being further associated with the reference state of charge ($\rho_0$-$\rho_8$) of the respective reference voltage/current characteristic ($V_0$(I)-$V_8$(I)); and

   - comparing the said operative value (A; V($I_m$)) with the said comparison values ($A_0$-$A_8$; $V_0$($I_m$)-$V_8$($I_m$)) to determine the said current state of charge ($\rho_{i,k}$) of the said storage unit.

4. Method according to Claim 3, **characterized in that** the said phase of calculating an operative value (A) comprises the phase of:

   - calculating the integral of the said current operative voltage/current characteristic (V(I)) between a first and a second pre-determined integration limit;

   and **in that** the said phase of calculating a plurality of comparison values ($A_0$-$A_8$) comprises the phase of:

   - calculating the integral of each of the said reference voltage/current characteristics ($V_0$(I)-$V_8$(I)) between the said first and second pre-determined integration limit.

5. Method according to Claim 3, **characterized in that** the said phase of calculating an operative value (V($I_m$)) comprises the phases of:

   - calculating a mean current value ($I_m$) on the basis of the said instantaneous current values ($I_i$)

of the said pairs of voltage/current values ($V_i$, $I_i$);

- determining an operative point ($V(I_m)$) of the said current operative voltage/current characteristic ($V(I)$) corresponding to the said mean current value ($I_m$);

and **in that** the said phase of calculating a plurality of comparison values ($V_0$ ($I_m$) -$V_8$ ($I_m$)) comprises the phase of:

- determining, for each of the said reference voltage/current characteristics ($V_0(I)$-$V_8(I)$), a respective reference point ($V_0(I_m)$-$V_8(I_m)$) corresponding to the said mean current value ($I_m$).

6. Method according to one of Claims 3 to 5, **characterized in that** the said comparison values ($A_0$-$A_8$; $V_0(I_m)$-$V_8(I_m)$) define a sequence of ordered consecutive values and **in that** the said phase of comparing the said operative value ($A$; $V(I_m)$) with the said comparison values ($A_0$-$A_8$; $V_0(I_m)$-$V_8(I_m)$) comprises the phases of:

- determining, from among the said plurality of comparison values ($A_0$-$A_8$; $V_0(I_m)$-$V_8(I_m)$), at least one first and one second comparison value ($A_i$, $A_{i+1}$; $V_i(I_m)$, $V_{i+1}(I_m)$) consecutive between them and among which is included the said operative value ($A$; $V(I_m)$);

- determining a first and a second reference state of charge ($\rho_i$, $\rho_{i+1}$) each associated with a respective one of the said first and second comparison value ($A_i$, $A_{i+1}$; $V_i(I_m)$, $V_{i+1}(I_m)$);

- comparing the said operative value ($A$; $V(I_m)$) with the said first and second comparison value ($A_i$, $A_{i+1}$; $V_i(I_m)$, $V_{i+1}(I_m)$);

- determining an operative relationship between the said operative value ($A$; $V(I_m)$) and the said first and second comparison value ($A_i$, $A_{i+1}$; $V_i(I_m)$, $V_{i+1}(I_m)$); and

- determining the said current state of charge ($\rho_{i,k}$) on the basis of the said first and second reference state of charge ($\rho_i$, $\rho_{i+1}$) and the said operative relationship.

7. Method according to Claim 6, **characterized in that** the said phase of determining an operative relationship comprises the phases of:

- sub-dividing the inclusive interval between the said first and second comparison value ($A_i$, $A_{i+1}$; $V_i(I_m)$, $V_{i+1}(I_m)$) into a plurality of sub-intervals each associated with a respective comparison value ($A_{i,0}$-$A_{i,9}$; $V_{i,0}(I_m)$ -$V_{i,9}(I_m)$);

- comparing the said operative value ($A$; $V(I_m)$) with the said comparison values ($A_{i,0}$-$A_{i,9}$; $V_{i,0}(I_m)$-$V_{i,9}(I_m)$);

- determining, from among the said comparison values ($A_{i,0}$-$A_{i,9}$; $V_{i,0}(I_m)$ -$V_{i,9}(I_m)$), a specific comparison value ($A_{i,k}$; $V_{i,k}(I_m)$) closest to the said operative value ($A$; $V(I_m)$);

- sub-dividing the inclusive interval between the said first and second reference state of charge ($\rho_i$; $\rho_{i+1}$) into a plurality of sub-intervals each associated with a respective sub-division value ($\rho_{i,0}$-$\rho_{i,9}$);

- associating each of the said sub-division values ($\rho_{i,0}$-$\rho_{i,9}$) with a corresponding one of the said comparison values ($A_{i,0}$-$A_{i,9}$; $V_{i,0}(I_m)$-$V_{i,9}(I_m)$); and

- determining, from among the said sub-division values ($\rho_{i,0}$-$\rho_{i,9}$), a specific sub-division value ($\rho_{i,k}$) associated with the said specific comparison value ($A_{i,k}$; $V_{i,k}(I_m)$), the said specific sub-division value ($\rho_{i,k}$) representing the current state of charge of the said storage unit.

8. Method according to Claim 7, **characterized in that** it further comprises the phases of:

- comparing the said specific sub-division value ($\rho_{i,k}$) with at least a first pre-determined threshold value ($\rho_{k0}$);

- indicating a sufficient charge state of the said storage unit whenever the said specific sub-division value ($\rho_{i,k}$) is less than the said first predetermined threshold value ($\rho_{k0}$); and

- indicating at least a reduced charge state of the said storage unit whenever the said specific sub-division value ($\rho_{i,k}$) is greater than the said first predetermined threshold value ($\rho_{k0}$).

9. Method according to Claim 8, **characterized in that** it further comprises the phase of:

- comparing the said specific sub-division value ($\rho_{i,k}$) with a second pre-determined threshold value ($\rho_{k1}$), the said second pre-determined threshold value ($\rho_{k1}$) being greater than the said first pre-determined threshold value ($\rho_{k0}$); and

- indicating an insufficient charge state of the said storage unit whenever the said specific sub-division value ($\rho_{i,k}$) is greater than the said second predetermined threshold value ($\rho_{k1}$).

10. Device for determining the current state of charge of an electrical energy storage unit, which comprises, in combination:

- means for acquiring (2-22) a plurality of pairs of voltage/current values ($V_i$, $I_i$), each comprising an instantaneous value of voltage ($V_i$) generated by the said storage unit and a corresponding instantaneous value of current ($I_i$) supplied by the said storage unit;

- means for calculating (23) a curve (V(I)) interpolating the said instantaneous voltage and current values ($V_i$, $I_i$), the said interpolating curve defining a current operative voltage/current characteristic (V(I)) of the said storage unit;

- means for storing (24) a plurality of reference windows sub-dividing a graph of the voltage/current characteristics and each associated with a corresponding reference state of charge ($\rho_i$, $\rho_{i+1}$) of the said storage unit;

- means for associating (25) the said current operative voltage/current characteristic (V(I)) with the said graph of the voltage/current characteristics;

- means for identifying (26, 26) a specific reference window from among the said reference windows, containing the said operative voltage/current characteristic (V(I));

- means for assessing (28) a specific reference state of charge ($\rho_i$, $\rho_{i+1}$) of the storage unit associated with the said specific reference window identified; and

- means for determining (29-38) the said current state of charge ($\rho_k$) on the basis of the said specific reference state of charge ($\rho_i$, $\rho_{i+1}$).

**Patentansprüche**

1. Verfahren zum Bestimmen des momentanen Ladezustandes einer Speichereinheit für elektrische Energie, das in Kombination die folgenden Phasen umfasst.

- Erfassen mehrerer Spannungs-/Stromwert-Paare ($V_i$, $I_i$), wovon jedes einen momentanen Wert ($V_i$) der von der Speichereinheit erzeugten Spannung sowie einen entsprechenden momentanen Wert ($I_i$) des von der Speichereinheit gelieferten Stroms umfasst;

- Bestimmen einer Kurve (V(I)), die die Paare von Spannungs/Stromwerten ($V_i$, $I_i$) interpoliert, wobei die Interpolationskurve eine momentane Spannungs-/Strom-Kennlinie (V(I)) des Betriebs der Speichereinheit definiert;

- Unterteilen eines Graphen der Spannungs-/Strom-Kennlinie der Speichereinheit in mehrere Referenzfenster, wovon jedes einem entsprechenden Referenz-Ladezustand ($\rho_i$, $\rho_{i+1}$) der Speichereinheit zugeordnet ist;

- Zuordnen der momentanen Spannungs-/Strom-Kennlinie (V(I)) des Betriebs zu dem Graphen der Spannungs-/Strom-Kennlinie;

- identifizieren eines bestimmten Referenzfensters, das die momentane Spannungs-/Strom-Kennlinie (V(I)) des Betriebs enthält, unter den Referenzfenstern;

- Bestimmen eines bestimmten Referenz-Ladezustands ($\rho_i$, $\rho_{i+1}$), der dem identifizierten bestimmten Referenzfenster zugeordnet ist, unter den Referenz-Ladezuständen ($\rho_0$-$\rho_8$); und

- Bestimmen des momentanen Ladezustands ($\rho_{i,k}$) der Speichereinheit auf der Grundlage des bestimmten Referenz-Ladezustands ($\rho_i$, $\rho_{i+1}$).

2. Verfahren nach Anspruch 1, **dadurch gekennzeichnet, dass** die Phase des Unterteilens eines Graphen der Spannungs-/Strom-Kennlinie die folgende Phase umfasst:

- Zuordnen mehrerer Referenz-Spannungs-/Strom-Kennlinien ($V_0(t)$-$V_8(I)$) der Speichereinheit zu dem Graphen der Spannungs-/Strom-Kennlinie, wobei jede der Referenz-Spannungs-/Strom-Kennlinien ($V_0(I)$-$V_8(I)$) einem entsprechenden Referenz-Ladezustand ($\rho_0$-$\rho_8$) der Speichereinheit zugeordnet ist und jedes Paar benachbarter Referenz-Spannungs-/Strom-Kennlinien ($V_i(I)$, $V_{i+1}(I)$) ein entsprechendes der Referenzfenster begrenzt.

3. Verfahren nach Anspruch 2, **dadurch gekennzeichnet, dass** die Phase des Identifizierens eines bestimmten Referenzfensters die folgenden Phasen umfasst:

- Berechnen eines Betriebswerts (A; $V(I_m)$), der der momentanen Spannungs-/Strom-Kennlinie (V(I)) des Betriebs zugeordnet ist;

- Berechnen mehrerer Vergleichswerte ($A_0$-$A_8$; $V_0(I_m)$-$V_8(I_m)$), wovon jeder einer entsprechenden der Referenz-Spannungs-/Strom-Kennlinien ($V_0(I)$-$V_8(I)$) zugeordnet ist, wobei jeder der Vergleichswerte ($A_0$-$A_8$; $V_0(I_m)$-$V_8(I_m)$) ferner dem Referenz-Ladezustand ($\rho_0$-$\rho_8$) der ent-

sprechenden Referenz-Spannungs/Strom-Kennlinie ($V_0(I)$-$V_8(I)$) zugeordnet ist; und

- Vergleichen des Betriebswertes (A; $V(I_m)$) mit den Vergleichswerten ($A_0$-$A_8$; $V_0(I_m)$-$V_8(I_m)$), um den momentanen Ladezustand ($\rho_{i,k}$) der Speichereinheit zu bestimmen.

**4.** Verfahren nach Anspruch 3, **dadurch gekennzeichnet, dass** die Phase des Berechnens eines Betriebswertes (A) die folgende Phase umfasst:

- Berechnen des Integrals der momentanen Spannungs-/Strom-Kennlinie ($V(I)$) des Betriebs zwischen einer ersten und einer zweiten vorgegebenen Integrationsgrenze;

und dass die Phase des Berechnens mehrerer Vergleichswerte ($A_0$-$A_8$) die folgende Phase umfasst:

- Berechnen des Integrals jeder der Referenz-Spannungs-/Strom-Kennlinien ($V_0(I)$-$V_8(I)$) zwischen der ersten und der zweiten vorgegebenen Integrationsgrenze.

**5.** Verfahren nach Anspruch 3, **dadurch gekennzeichnet, dass** die Phase des Berechnens eines Betriebswertes ($V(I_m)$) die folgenden Phasen umfasst:

- Berechnen eines mittleren Stromwertes ($I_m$) auf der Grundlage der momentanen Stromwerte ($I_i$) der Paare von Spannungs-/Stromwerten ($V_i$, $I_i$);
- Bestimmen eines Betriebspunkts ($V(I_m)$) der momentanen Spannungs-/Strom-Kennlinie ($V(I)$) des Betriebs, der dem mittleren Stromwert ($I_m$) entspricht;

und dass die Phase des Berechnens mehrerer Vergleichswerte ($V_0(I_m)$-$V_8(I_m)$) die folgende Phase umfasst:

- Bestimmen eines entsprechenden Referenzpunkts ($V_0(I_m)$-$V_8(I_m)$), der dem mittleren Stromwert ($I_m$) entspricht, für jede der Referenz-Spannungs-/Strom-Kennlinien ($V_0(1)$-$V_8(I)$).

**6.** Verfahren nach einem der Ansprüche 3 bis 5, **dadurch gekennzeichnet, dass** die Vergleichswerte ($A_0$-$A_8$; $V_0(I_m)$-$V_8(I_m)$) eine Folge geordneter, aufeinander folgender Werte definieren und dass die Phase des Vergleichens des Betriebswertes (A; $V(I_m)$) mit den Vergleichswerten ($A_0$-$A_8$; $V_0(I_m)$-$V_8(I_m)$) die folgenden Phasen umfasst:

- Bestimmen wenigstens eines ersten und eines zweiten Vergleichswertes ($A_i$, $A_{i+1}$; $V_i(I_m)$, $V_{i+1}(I_m)$), die aufeinander folgen und zwischen denen der Betriebswert (A; $V(I_m)$) enthalten ist, aus den mehreren Vergleichswerten ($A_0$-$A_8$; $V_0(I_m)$-$V_8(I_m)$);
- Bestimmen eines ersten und eines zweiten Referenz-Ladezustandes ($\rho_i$, $\rho_{i+1}$), wovon jeder einem entsprechenden des ersten und des zweiten Vergleichswertes ($A_i$, $A_{i+1}$; $V_i(I_m)$, $V_{i+1}(I_m)$) zugeordnet ist;
- Vergleichen des Betriebswertes ($A_i$ $V(I_m)$) mit dem ersten und dem ersten und mit dem zweiten Vergleichswert ($A_i$, $A_{i+1}$; $V_i(I_m)$, $V_{i+1}(I_m)$);
- Bestimmen einer funktionalen Beziehung zwischen dem Betriebswert (A; $V(I_m)$) und dem ersten und dem zweiten Vergleichswert ($A_i$, $A_{i+1}$; $V_i(I_m)$, $V_{i+1}(I_m)$); und
- Bestimmen des momentanen Ladezustandes ($\rho_{i,k}$) auf der Grundlage des ersten und des zweiten Referenz-Ladezustandes ($\rho_i$, $\rho_{i+1}$) und der funktionalen Beziehung.

**7.** Verfahren nach Anspruch 6, **dadurch gekennzeichnet, dass** die Phase des Bestimmens einer funktionalen Beziehung die folgenden Phasen umfasst:

- Unterteilen des Intervalls zwischen dem ersten und dem zweiten Vergleichswert ($A_i$, $A_{i+1}$; $V_i(I_m)$, $V_{i+1}(I_m)$) einschließlich der Intervallgrenzen in mehrere Unterintervalle, wovon jedes einem entsprechenden Vergleichswert ($A_{i,0}$-$A_{i;9}$; $V_{i,0}(I_m)$-$V_{i,9}(I_m)$) zugeordnet ist;
- Vergleichen des Betriebswertes (A; $V(I_m)$) mit den Vergleichswerten ($A_{i,0}$-$A_{i,9}$; $V_{i,0}(I_m)$-$V_{i,9}(I_m)$);
- Bestimmen eines bestimmten Vergleichswertes ($A_{i,k}$ $V_{i,k}(I_m)$), der am nähesten bei dem Betriebswert (A; $V(I_m)$) liegt, unter den Vergleichswerten ($A_{i,0}$-$A_{i,9}$; $V_{i,0}(I_m)$-$V_{i,9}(I_m)$);

Unterteilen des Intervalls zwischen dem ersten und dem zweiten Referenz-Ladezustand ($\rho_i$; $\rho_{i+1}$) einschließlich der Intervallgrenzen in mehrere Unterintervalle, wovon jedes einem entsprechenden Unterteilungswert ($\rho_{i,0}$-$\rho_{i,9}$) zugeordnet ist;

- Zuordnen jedes der Unterteilungswerte ($\rho_{i,0}$-$\rho_{i,9}$) zu einem entsprechenden der Vergleichswerte ($A_{i,0}$ $A_{i,9}$; $V_{i,0}(I_m)$-$V_{i,9}(I_m)$); und
- Bestimmen eines bestimmten Unterteilungswertes ($\rho_{i,k}$), der dem bestimmten Vergleichswert ($A_{j,k}$; $V_{i,k}(I_m)$) zugeordnet ist, unter den Unterteilungswerten ($\rho_{i,0}$-$\rho_{1,9}$), wobei der bestimmte Unterteilungswert ($\rho_{i,k}$) den momentanen Ladezustand der Speichereinheit repräsentiert.

**8.** Verfahren nach Anspruch 7, **dadurch gekennzeichnet, dass** es ferner die folgenden Phasen umfasst:

- Vergleichen des bestimmten Unterteilungswertes ($\rho_{i,k}$) mit wenigstens einem ersten vorgegebenen Schwellenwert ($\rho_{k0}$);
- Anzeigen eines ausreichenden Ladezustandes der Speichereinheit, wann immer der bestimmte Unterteilungswert ($\rho_{i,k}$) kleiner als der erste vorgegebene Schwellenwert ($\rho_{k0}$) ist; und
- Anzeigen zumindest eines verringerten Ladezustandes der Speichereinheit, wann immer der bestimmte Unterteilungswert ($\rho_{i,k}$) größer als der erste vorgegebene Schwellenwert ($\rho_{k0}$) ist.

**9.** Verfahren nach Anspruch 8, **dadurch gekennzeichnet, dass** es ferner die folgende Phase umfasst:

- Vergleichen des bestimmten Unterteilungswertes ($\rho_{i,k}$) mit einem zweiten vorgegebenen Schwellenwert ($\rho_{k1}$), wobei der zweite vorgegebene Schwellenwert ($\rho_{k1}$) größer als der erste vorgegebene Schwellenwert ($\rho_{k0}$) ist; und
- Anzeigen eines unzureichenden Ladezustandes der Speichereinheit, wann immer der bestimmte Unterteilungswert ($\rho_{i,k}$) größer als der zweite vorgegebene Schwellenwert ($\rho_{k1}$) ist

**10.** Vorrichtung zum Bestimmen des momentanen Ladezustandes einer Speichereinheit für elektrische Energie, die in Kombination umfasst

- Mittel (2-22) zum Erfassen mehrerer Paare von Spannungs-/Strom-Werten ($V_i$, $I_i$), wovon jedes einen momentanen Wert ($V_i$) der von der Speichereinheit erzeugten Spannung und einen entsprechenden momentanen Wert ($I_i$) des von der Speichereinheit gelieferten Stroms umfasst;
- Mittel (23) zum Berechnen einer Kurve (V(I)), die die momentanen Spannungs- und Stromwerte ($V_i$, $I_i$) interpoliert, wobei die Interpolationskurve eine ■ momentane Spannungs-/Strom-Kennlinie (V(I)) des Betriebs der Speichereinheit definiert;
- Mittel (24) zum Speichern mehrerer Referenzfenster, die einen Graphen der Spannungs-/Strom-Kennlinie unterteilen und jeweils einem entsprechenden Referenz-Ladezustand ($\rho_i$, $\rho_{i+1}$) zugeordnet sind;
- Mittel (25) zum Zuordnen der momentanen Spannungs-/Strom-Kennlinie (V(I)) des Betriebs zu dem Graphen der Spannungs-/Strom-Kennlinie;
- Mittel (26, 26) zum identifizieren eines bestimmten Referenzfensters unter den Referenzfenstem, das die Spannungs-/Strom-Kennlinie (V(I)) des Betriebs enthält;
- Mittel (28) zum Bewerten eines bestimmten Referenz-Ladezustandes ($\rho_i$, $\rho_{i+1}$) der Speichereinheit, der dem identifizierten bestimmten Referenzfenster zugeordnet ist; und
- Mittel (29-38) zum Bestimmen des momentanen Ladezustandes ($\rho_k$) auf der Grundlage des bestimmten Referenz-Ladezustandes ($\rho_i$, $\rho_{i+1}$).

**Revendications**

**1.** Procédé de détermination de l'état de charge courant d'une unité de stockage d'énergie électrique, qui comprend, en combinaison, les étapes consistant à :

acquérir une pluralité de paires de valeurs tension/courant ($V_i$, $I_i$), comprenant chacune une valeur instantanée de tension ($V_i$) produite par ladite unité de stockage et une valeur instantanée correspondante de courant ($I_i$) fournie par ladite unité de stockage ;
déterminer une courbe (V(I)) interpolant lesdites paires de valeurs tension/courant ($V_i$, $I_i$), ladite courbe d'interpolation définissant une caractéristique courante fonctionnelle tension/courant (V(I)) de ladite unité de stockage ;
subdiviser un graphique des caractéristiques tension/courant de ladite unité de stockage en une pluralité de fenêtres de référence associées chacune à un état de charge de référence correspondant ($\rho_i$, $\rho_{i+1}$) de l'unité de stockage ;
associer ladite caractéristique courante fonctionnelle tension/courant (V(I)) audit graphique des caractéristiques tension/courant ;
identifier, parmi lesdites fenêtres de référence, une fenêtre de référence spécifique contenant ladite caractéristique courante fonctionnelle tension/courant (V(I)) ;
déterminer, parmi lesdits états de charge de référence ($\rho_0$ à $\rho_8$), un état de charge de référence spécifique ($\rho_i$, $\rho_{i+1}$) associé à ladite fenêtre de référence spécifique identifiée ; et
déterminer ledit état de charge courant ($\rho_{i,k}$) de ladite unité de stockage en se basant sur ledit état de charge de référence spécifique ($\rho_i$, $\rho_{i+1}$).

**2.** Procédé selon la revendication 1, **caractérisé en ce que** ladite étape de subdivision d'un graphique des caractéristiques tension/courant comprend la phase consistant à :

associer une pluralité de caractéristiques de référence tension/courant ($V_0(I)$ à $V_8(I)$) de ladite unité de stockage audit graphique des caractéristiques tension/courant, chacune desdites caractéristiques de référence tension/courant ($V_0$(I) à $V_8$(I)) étant associée à un état de charge de référence correspondant ($\rho_0$ à $\rho_8$) de l'unité de stockage et chaque paire de caractéristiques de référence adjacentes tension/courant ($V_i$(I), $V_{i+1}$(I)) délimitant une fenêtre respective parmi lesdites fenêtres de référence.

**3.** Procédé selon la revendication 2, **caractérisé en ce que** ladite étape d'identification d'une fenêtre de référence spécifique comprend les phases consistant à :

calculer une valeur fonctionnelle (A; $V(I_m)$) associée à ladite caractéristique courante fonctionnelle tension/courant (V(I)) ;
calculer une pluralité de valeurs de comparaison ($A_0$ à $A_8$; $V_0(I_m)$ à $V_8(I_m)$), associées chacune à une caractéristique respective parmi lesdites caractéristiques de référence tension/courant ($V_0$(I) à $V_8$(I)), chacune desdites valeurs de comparaison ($A_0$ à $A_8$; $V_0(I_m)$ à $V_8(I_m)$ étant, en outre, associée à l'état de charge de référence ($\rho_0$ à $\rho_8$) de la caractéristique de référence respective tension/courant ($V_0$(I) à $V_8$(I)) ; et
comparer ladite valeur fonctionnelle (A; $V(I_m)$) auxdites valeurs de comparaison ($A_0$ à $A_8$; $V_0(I_m)$ à $V_8(I_m)$) pour déterminer ledit état de charge courant ($\rho_i$, $\rho_k$) de ladite unité de stockage.

**4.** Procédé selon la revendication 3, **caractérisé en ce que** ladite phase de calcul d'une valeur fonctionnelle (A) comprend la phase consistant à :

calculer l'intégrale de ladite caractéristique courante fonctionnelle tension/courant (V(I)) entre une première et une seconde limite d'intégration prédéterminées ;
et **en ce que** ladite phase de calcul d'une pluralité de valeurs de comparaison ($A_0$ à $A_8$) comprend la phase consistant à :

calculer l'intégrale de chacune desdites caractéristiques de référence tension/courant ($V_0$(I) à $V_8$(I)) entre lesdites première et seconde limites d'intégration prédéterminées.

**5.** Procédé selon la revendication 3, **caractérisé en ce que** ladite phase de calcul d'une valeur fonctionnelle ($V(I_m)$) comprend les phases consistant à :

calculer une valeur de courant moyen ($I_m$) en se basant sur lesdites valeurs de courant instantané ($I_i$) desdites paires de valeurs tension/courant ($V_i$,$I_i$) ;

déterminer un point de fonctionnement ($V(I_m)$) de ladite caractéristique courante fonctionnelle tension/courant (V(I)) correspondant à ladite valeur de courant moyen ($I_m$) ;
et **en ce que** ladite phase de calcul d'une pluralité de valeurs de comparaison ($V_0(I_m)$ à $V_8(I_m)$) comprend les phases consistant à :

déterminer, pour chacune desdites caractéristiques de référence tension/courant ($V_0$(I) à $V_8$(I)), un point de référence respectif ($V_0(I_m)$ à $V_8(I_m)$) correspondant à ladite valeur de courant moyen ($I_m$).

**6.** Procédé selon l'une des revendications 3 à 5, **caractérisé en ce que** lesdites valeurs de comparaison ($A_0$ à $A_8$; $V_0(I_m)$ à $V_8(I_m)$) définissent une séquence de valeurs consécutives ordonnées et **en ce que** ladite phase de comparaison de ladite valeur fonctionnelle (A; $V(I_m)$) auxdites valeurs de comparaison ($A_0$ à $A_8$; $V_0(I_m)$ à $V_8(I_m)$) comprend les phases consistant à :

déterminer, parmi ladite pluralité de valeurs de comparaison ($A_0$ à $A_8$; $V_0(I_m)$ à $V_8(I_m)$), au moins une première et une seconde valeur de comparaison ($A_i$, $A_{i+1}$; $V_i(I_m)$, $V_{i+1}(I_m)$) consécutives entre elles et parmi lesquelles est incluse ladite valeur fonctionnelle (A; $V(I_m)$) ;
déterminer un premier et un second état de charge de référence ($\rho_i$, $\rho_{i+1}$), associés chacun à une valeur respective parmi ladite première et ladite seconde valeur de comparaison ($A_i$, $A_{i+1}$; $V_i(I_m)$, $V_{i+1}(I_m)$) ;
comparer ladite valeur fonctionnelle (A; $V(I_m)$) auxdites première et seconde valeurs de comparaison ($A_i$, $A_{i+1}$; $V_i(I_m)$, $V_{i+1}(I_m)$ ;
déterminer une relation fonctionnelle entre ladite valeur fonctionnelle (A; $V(I_m)$) et lesdites première et seconde valeurs de comparaison ($A_i$, $A_{i+1}$; $V_i(I_m)$, $V_{i+1}(I_m)$) ; et
déterminer ledit état de charge courant ($\rho_{i,k}$) en se basant sur lesdits premier et second états de charge de référence ($\rho_i$, $\rho_{i+1}$) et ladite relation fonctionnelle.

**7.** Procédé selon la revendication 6, **caractérisé en ce que** ladite phase de détermination d'une relation fonctionnelle comprend les phases consistant à :

subdiviser l'intervalle compris entre lesdites première et seconde valeurs de comparaison ($A_i$, $A_{i+1}$; $V_i(I_m)$, $V_{i+1}(I_m)$) en une pluralité de sous-intervalles associés chacun à une valeur de comparaison respective ($A_{i,0}$ à $A_{i,9}$; $V_{i,0}(I_m)$ à $V_{i,9}(I_m)$) ;
comparer ladite valeur fonctionnelle (A; $V(I_m)$) auxdites valeurs de comparaison ($A_{i,0}$ à $A_{i,9}$;

$V_{i,0}(I_m)$ à $V_{i,9}(I_m))$ ;

déterminer, parmi lesdites valeurs de comparaison ($A_{i,0}$ à $A_{i,9}$; $V_{i,0}(I_m)$ à $V_{i,9}(I_m)$), une valeur de comparaison spécifique ($A_{i,k}$; $V_{i,k}(I_m)$) la plus proche de ladite valeur fonctionnelle ($A$; $V(I_m)$) ;

subdiviser l'intervalle compris entre lesdits premier et second états de charge de référence ($\rho_i$, $\rho_{i+1}$) en une pluralité de sous-intervalles associés chacun à une valeur de subdivision respective ($\rho_{i,0}$ à $\rho_{i,9}$) ;

associer chacune desdites valeurs de subdivision ($\rho_{i,0}$ à $\rho_{i,9}$) à une valeur correspondante parmi lesdites valeurs de comparaison ($A_{i,0}$ $A_{i,9}$; $V_{i,0}(I_m)$ à $V_{i,9}(I_m)$) ; et

déterminer, parmi lesdites valeurs de subdivision ($\rho_{i,0}$ à $\rho_{i,9}$), une valeur de subdivision spécifique ($\rho_{i,k}$) associée à ladite valeur de comparaison spécifique ($A_{i,k}$; $V_{i,k}(I_m)$), ladite valeur de subdivision spécifique ($\rho_{i,k}$) représentant l'état de charge courant de ladite unité de stockage.

8. Procédé selon la revendication 7, **caractérisé en ce qu'**il comprend, en outre, les phases consistant à :

comparer ladite valeur de subdivision spécifique ($\rho_{i,k}$) au moins à une première valeur de seuil prédéterminée ($\rho_{k0}$) ;

indiquer un état de charge suffisant de ladite unité de stockage à chaque fois que ladite valeur de subdivision spécifique ($\rho_{i,k}$) est inférieure à ladite première valeur de seuil prédéterminée ($\rho_{k0}$) ; et

indiquer au moins un état de charge réduit de ladite unité de stockage à chaque fois que ladite valeur de subdivision spécifique ($\rho_{i,k}$) est supérieure à ladite première valeur de seuil prédéterminée ($\rho_{k0}$).

9. Procédé selon la revendication 8, **caractérisé en ce qu'**il comprend, en outre, les phases consistant à :

comparer ladite valeur de subdivision spécifique ($\rho_{i,k}$) à une seconde valeur de seuil prédéterminée ($\rho_{k1}$), ladite seconde valeur de seuil prédéterminée ($\rho_{k1}$) étant supérieure à ladite première valeur de seuil prédéterminée ($\rho_{k0}$) ; et

indiquer un état de charge insuffisant de ladite unité de stockage à chaque fois que ladite valeur de subdivision spécifique ($\rho_{i,k}$) est supérieure à ladite seconde valeur de seuil prédéterminée ($\rho_{k1}$).

10. Dispositif pour déterminer l'état de charge courant d'une unité de stockage d'énergie électrique, qui comprend, en combinaison :

un moyen pour acquérir (2 à 22) une pluralité de paires de valeurs tension/courant ($V_i$, $I_i$), comprenant chacune une valeur instantanée de tension ($V_i$) produite par ladite unité de stockage et une valeur instantanée correspondante de courant ($I_i$) fournie par ladite unité de stockage ;

un moyen pour calculer (23) une courbe ($V(I)$) interpolant lesdites valeurs instantanées de tension et de courant ($V_i$, $I_i$), ladite courbe d'interpolation définissant une caractéristique courante fonctionnelle tension/courant ($V(I)$) de ladite unité de stockage ;

un moyen pour stocker (24) une pluralité de fenêtres de référence subdivisant un graphique des caractéristiques tension/courant chacune étant associée à un état de charge de référence correspondant ($\rho_i$, $\rho_{i+1}$) de ladite unité de stockage ;

un moyen pour associer (25) ladite caractéristique courante fonctionnelle tension/courant ($V(I)$) audit graphique des caractéristiques tension/courant ;

un moyen pour identifier (26, 26) une fenêtre de référence spécifique parmi lesdites fenêtres de référence, contenant ladite caractéristique courante fonctionnelle tension/courant ($V(I)$) ;

un moyen pour déterminer (28) un état de charge de référence spécifique ($\rho_i$, $\rho_{i+1}$) de l'unité de stockage associé à ladite fenêtre de référence spécifique identifiée ; et

un moyen pour déterminer (29 à 38) ledit état de charge courant ($\rho_k$) en se basant sur ledit état de charge de référence spécifique ($\rho_i$, $\rho_{i+1}$).

Fig. 1

Fig. 2

Fig. 3

Fig. 4

Fig.5

START

20 ACQUIRE AND STORE $V_i$, $I_i$

21 CALCULATE $Ah_1$

22 $Ah_1 > Ah_0$ ?

NO

YES

23 DETERMINE V(I)

24 SUB-DIVIDE GRAPH OF VOLTAGE/CURRENT CHARACTERISTICS AND STORE

25 ASSOCIATE CHARACTERISTIC V(I)

26 CALCULATE OPERATIVE VALUE AND COMPARISON VALUES

27 DETERMINE 1ST AND 2ND COMPARISON VALUE

28 DETERMINE 1ST AND 2ND REFERENCE VALUE OF DEPTH OF DISCHARGE

29 SUB-DIVIDE INTERVAL BETWEEN 1ST AND 2ND COMPARISON VALUE

30 COMPARE OPERATIVE VALUE WITH COMPARISON VALUES

31 DETERMINE SPECIFIC COMPARISON VALUE

32 SUB-DIVIDE INTERVAL BETWEEN 1ST AND 2ND REFERENCE VALUE OF DEPTH OF DISCHARGE

A

Fig. 6

Fig. 7

START

40 — $A = \int\limits_0^{s_0} V(I)\,dI$

41 — $A_. = \int\limits_0^{s_0} V_.(I)\,dI$

Fig. 8

START

45 — DETERMINE
$I_m$

46 — DETERMINE
$V(I_m)$

47 — DETERMINE
$V_0(I_m) - V_s(I_m)$

Fig. 9